# EUROPEAN PATENT APPLICATION

(11) **EP 4 815 688 A1**
(43) Date of publication of application: **30.09.2026**
(21) Application number: 25223640.1
(22) Date of filing: 16.12.2025
(51) Int. Cl.: H10H 29/30, H10H 20/856, G09G 3/32

(54) **DISPLAY APPARATUS, AND MANUFACTURING METHOD THEREFOR AND RELATED CONTROLLING METHOD**

(30) Priority: 27.03.2025 US 202519091914
(71) Applicant: INTEL Corporation, Santa Clara, CA 95054 (US)
(72) Inventor: AHMED, Khaled, San Jose, 95123 (US); FRYMAN, Joshua B., Corvallis, 97330 (US)
(74) Representative: 2SPL Patentanwälte PartG mbB

(57) **Abstract**

Provided includes a display apparatus including a plurality of light emitters configured for both light emission and detection. Furthermore, processing circuitry selectively applies forward bias for light emission and reverse bias for light detection. Moreover, control circuitry manages display mode switching, brightness adjustment, and pixel aging compensation, with integrated sensors detecting ambient light and user proximity. Provided further includes a display apparatus that may flexibly switch between a privacy mode and a collaboration mode by using two types of MicroLEDs with different emission angles.

## Description

### Background

Light emitting diodes (LEDs) are semiconductor devices that emit light when an electric current passes through them. In the display area, LEDs may be used for high-brightness, energy-efficient, and long-lasting screens. They may serve as backlights in LCDs or as individual pixels in LED displays like OLED and Micro-LED. LEDs provide good contrast, color accuracy, and fast response times, making them popular for TVs, monitors, smartphones, and digital billboards.

### Brief description of the Figures

Some examples of apparatuses and/or methods will be described in the following by way of example only, and with reference to the accompanying figures, in which
Fig. 1 illustrates a laptop of an example, to which the photodetectors may be applied.
Fig. 2 illustrates a dual-function smart display 200 of an example.
Fig. 3 illustrates Type 1 and Type 2 LED emitters of an example.
Fig. 4 illustrates a portion of a display 400 including different types of LED emitters of an example.
Fig. 5 illustrates an architecture of a LED display 500 of an example.
Fig. 6 illustrates a diagram of manufacturing LED displays of an example.
Fig. 7 illustrates a diagram of pick-and-place (PnP) transfer of an example.
Fig. 8 illustrates structures of a plurality stages of an emitter with a narrow emission angle of an example.
Fig. 9 illustrates structures of a plurality stages of an emitter with a broad emission angle of an example.
Fig. 10 illustrates a block diagram of a display apparatus 1000 of an example.
Fig. 11 illustrates a block diagram of a display apparatus 1100 of an example.
Fig. 12 illustrates a block diagram of a light emitter 1200 of an example.
Fig. 13 illustrates a block diagram of a display apparatus 1300 of an example.
Fig. 14 illustrates a method 1400 of manufacturing a display apparatus of an example.
Fig. 15 illustrates a method 1500 of controlling a display apparatus of an example.
Fig. 16 illustrates a method 1600 of manufacturing a light emitter of an example.
Fig. 17 illustrates a method 1700 of manufacturing a display apparatus of an example.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures identical or similar reference numerals refer to identical or similar elements and/or features, which may be identical or implemented in a modified form while providing the identical or a similar function. The thickness of lines, layers and/or areas in the figures may also be exaggerated for clarification.

When two elements A and B are combined using an "or", this is to be understood as disclosing all possible combinations, i.e., only A, only B as well as A and B, unless expressly defined otherwise in the individual case. As an alternative wording for the identical combinations, "at least one of A and B" or "A and/or B" may be used. This applies equivalently to combinations of more than two elements.

**If** a singular form, such as "a", "an" and "the" is used and the use of only a single element is not defined as mandatory either explicitly or implicitly, further examples may also use several elements to implement the identical function. If a function is described below as implemented using multiple elements, further examples may implement the identical function using a single element or a single processing entity. **It** is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

**In** the following description, specific details are set forth, but examples of the technologies described herein may be practiced without these specific details. Well-known circuits, structures, and techniques have not been shown in detail to avoid obscuring an understanding of this description. "An example," "various examples," "some examples," and the like may include features, structures, or characteristics, but not every example necessarily includes the particular features, structures, or characteristics.

Some examples may have some, all, or none of the features described for other examples. "First," "second," "third," and the like describe a common element and indicate different instances of like elements being referred to. Such adjectives do not imply element item so described must be in a given sequence, either temporally or spatially, in ranking, or any other manner. "Connected" may indicate elements are in direct physical or electrical contact with each other and "coupled" may indicate elements co-operate or interact with each other, but they may or may be not in direct physical or electrical contact.

As used herein, the terms "operating", "executing", or "running" as they pertain to software or firmware in relation to a system, device, platform, or resource are used interchangeably and can refer to software or firmware stored in one or more computer-readable storage media accessible by the system, device, platform, or resource, even though the instructions contained in the software or firmware are not actively being executed by the system, device, platform, or resource.

The description may use the phrases "in an example/example," "in examples/examples," "in some examples/examples," and/or "in various examples/examples," each of which may refer to one or more of the identical or different examples. Furthermore, the terms "comprising," "including," "having," and the like, as used with respect to examples of the present disclosure, are synonymous. In the following, some examples are described in connection with MicroLEDs, but also other light emitting structures or light emitting diodes (e.g. inorganic or organic LEDs) may be used.

In some examples, the brightness of a display may rely on manual brightness adjustments or adjustments based on external ambient light sensors. The two manners may be inconsistent across different lighting conditions. In order to solve the issues related to brightness, aging compensation, which is often handled through software, may be applied. However, such aging compensation may lack precision at the pixel level and therefore lead to uneven image quality as parts of the display deteriorate at different rates. Proximity detection may be needed for fine brightness adjustment. However, proximity detection may require external sensors, which increases the cost and complexity of the display system.

In some examples, a technical scheme of using reverse-biased LEDs, such as MicroLEDs, as photodetectors is provided for at least one of the above problems. In some examples, the technical scheme may leverage LED, such as MicroLED, technology by using some LEDs on a display backplane as photodetectors through reverse bias, instead of forward biasing them for light emission. It may enable the LEDs to serve as photodetectors, enhancing the display's capabilities.

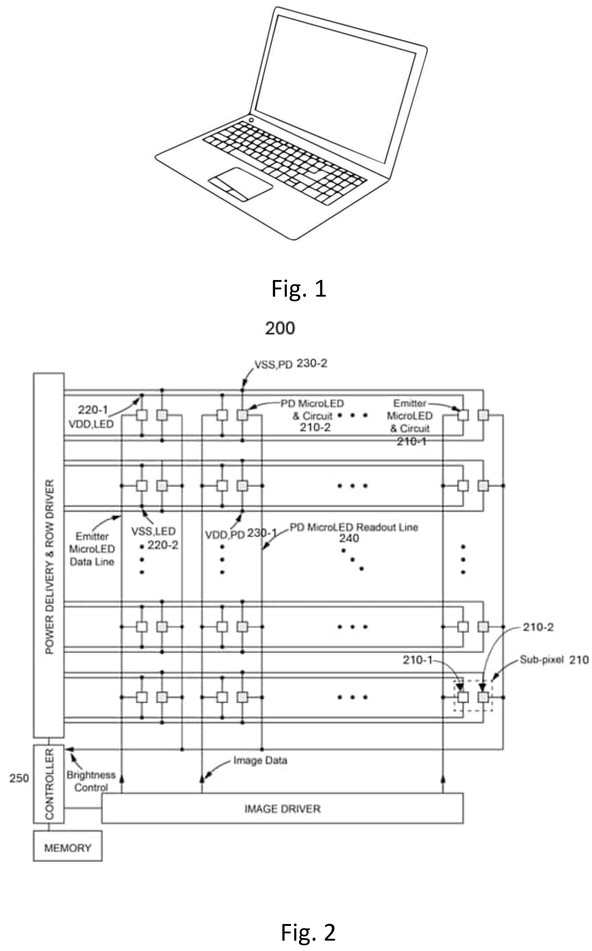

Fig. 1 illustrates a laptop of an example, to which the photodetectors may be applied. The photodetectors may also be applied to other devices having screens.

In some examples, the photodetectors implemented based on the LED, such as Micro LED, may be used to adjust the brightness of the display for a desired appearance. For example, a corner of the display may be in shadow while the rest is brightly lit. Without adjustment, the shaded area may appear less visible. In some examples, photodetectors may be placed next to individual LEDs or zones of LEDs to adjust their emitted light. Each photodetector may detect whether a light incident to the display originates from the LEDs or from ambient light.

In some examples, photodetectors may enable controllers to brighten or dim specific LEDs or zones to balance the overall display, improving visibility in different environments. Additionally, each LED may have a photodetector to monitor aging, allowing controllers to compensate for shifts in brightness or color as LEDs age. This may help maintain consistent display quality, even when some LEDs deteriorate faster than others. By adjusting driving strength based on data obtained by photodetectors, aged LEDs can be compensated to emit the desired brightness and color, extending the display's lifespan. In some examples, photodetectors may detect nearby objects, such as a user's finger or face, and then make control to the display based on the detected objects, such as turning on or turning off the display based on a hand gesture of a user.

Some of the above features may enhance display adaptability, quality, and energy efficiency for various use cases of display.

In some examples, photodetector circuitry may be made of Indium Gallium Zinc Oxide (IGZO) Thin-Film Transistors (TFTs) and/or n-channel Low-Temperature Polycrystalline Silicon (LTPS) TFTs. The photodetector circuitry may be integrated onto the display backplane, preferably positioned next to the driver circuits of the LED light emitters. This integration may enable the photodetector to work in tandem with the LEDs for light sensing and display control. The LED may refer to MicroLED or another type of LED.

Fig. 2 illustrates a dual-function smart display 200 of an example. Each sub-pixel 210 shown in Fig. 2 may comprise two MicroLEDs 210-1 and 210-2, where one 210-1 is biased to emit light using VDD, MicroLED bias lines 220-1 and VSS, MicroLED bias lines 220-2, and the other 210-2 is biased to detect light using VDD, PD MicroLED bias lines 230-1 and VSS, PD MicroLED bias lines 230-2. The readout lines 240 from the PD MicroLED circuit 210-2, the shaded square in the subpixel box, may provide a Brightness Control feedback signal to the Controller 250. In some examples, the PD MicroLED 210-2 may be the same device as Emitter MicroLED 210-1 but reverse biased using external lines. For example, a PD MicroLED 210-2 may be a reverse biased Emitter MicroLED, where the reverse bias may be implemented by external lines. In some examples, during the manufacture of the display, both PD MicroLED 210-2 and Emitter MicroLED 210-1 may be transferred to the display backplane at the same time to save cost.

In some examples, photo detecting circuitry may use a reverse-biased photodiode, which may be a reverse-biased MicroLED, as the light-sensing element. The TFTs, either IGZO or LTPS, may act as switching and amplification elements for reading the photocurrent generated when light strikes the photodiode.

In some examples, the photo detecting circuitry may implement the functions of photodiode sensing and/or switching based on TFT, and TFT amplification.

With respect to photodiode sensing, the reverse-biased MicroLED or a separate photodiode in some examples may detect incident light, generating a photocurrent proportional to light intensity of the detected incident light.

With respect to the switching based on TFT, the IGZO or LTPS TFT in the photo detecting circuitry may act as a switch to control the flow of this photocurrent. The TFT may be connected to the reverse-biased MicroLED or the photodiode at one end and may be connected to a readout line coupled with the display's control circuitry at the other end.

With respect to the TFT amplification, the TFT may amplify the photocurrent, as it may be weak. The amplified signal may be then sent to the display control unit, where it will be processed for brightness adjustment, aging compensation, and/or proximity detection.

In some examples, the photodetector circuit may be placed next to the MicroLED driver circuitry on the same backplane, sharing power lines and control signals. This proximity may reduce interconnect complexity and enable seamless interaction between light sensing and display driving functions.

In some examples, a quantum well-based MicroLED may be used as a photodetector, which may leverage the properties of the quantum well structure under reverse bias conditions. In the MicroLED design of some examples, the quantum well may be formed from a 5nm InGaN layer sandwiched between two 12nm un-doped GaN quantum barriers.

In some examples, the reverse bias to the MicroLED may make one or more depletion regions in the MicroLED to extend across the p-n junction and into the quantum well, creating a strong electric field. This field may separate any photo-generated electron-hole pairs when photons strike the device, such as in the InGaN quantum well. The photon absorption may be maximized or increased due to a narrower bandgap of InGaN in the quantum well.

In some examples, a MicroLED may be a type of p-n junction diode comprising p-type and n-type semiconductor materials. When a reverse bias is applied, negative voltage being input to the p-side and positive voltage being input to the n-side, the depletion region may expand across the junction. The depletion region may be an area depleted of free charge carriers, meaning very little current flows under normal conditions. In quantum well-based MicroLEDs of some examples, a thin InGaN (Indium Gallium Nitride) layer is sandwiched between GaN (Gallium Nitride) layers. When the depletion region extends into the quantum well, it may create a strong electric field across this region. When photons strike the quantum well, they may generate electron-hole pairs. The strong electric field in the depletion region may separate these charge carriers, directing electrons toward the n-side and holes toward the p-side. This separation may prevent recombination and allows the movement of charge carriers, resulting in a measurable photocurrent.

In some examples, when photons with energy greater than the InGaN bandgap hit the quantum well, they may generate electron-hole pairs in the well itself. These carriers may be rapidly separated by the strong electric field in the depletion region, leading to a photocurrent that can be detected. The presence of the AlGaN electron barrier layer may cause efficient confinement of carriers in the quantum well region, enhancing the sensitivity of photo detection. In some examples, the GaN barriers and AlGaN electron barrier may regulate the movement and recombination of charge carriers, optimizing the structure for efficient light detection. It may be especially effective in the blue to ultraviolet wavelength range, where GaN-based materials have strong light absorption properties. Thus, the quantum well structure may enhance the sensitivity and efficiency of the MicroLED photodetector.

The above examples may enable real-time feedback, allowing the photodetector circuit to adjust MicroLED brightness based on ambient lighting conditions and aging effects. This dynamic adjustment may enhance display efficiency and adaptability. Additionally, using IGZO or LTPS TFTs may provide high mobility, low power consumption, and precise control, making them well-suited for integration into modern high-resolution displays.

In the manufacture of the display, the use of TFT detection circuitry in some examples, as opposed to CMOS detection circuitry that might be transferred along with the photodetectors to each pixel of the display, may result in a cost reduction.

In some examples, TFTs may be deposited directly onto the display backplane using thin-film deposition techniques, e.g., IGZO or LTPS processes. This may reduce the need for separate transfer steps and simplifies integration with photodetectors.

In some examples, devices, such as laptops, smartphones, and tablets, are supposed to be capable of switching between a first display mode, such as a private mode and a second display mode, such as a collaborative mode. In some examples, the private mode may enable users to work discreetly, such as in public spaces, achieving that sensitive information or personal data is not visible to bystanders. In some examples, the private mode may be particularly useful for professionals handling confidential documents or for personal activities like banking or reading sensitive emails. In some examples, the collaborative mode may enable broader viewing angles, making it easier to share content with others during meetings, presentations, or collaborative tasks without the need for external displays.

In some examples, external accessories, such as privacy screens, are provided to obtain privacy for the device. For example, films or filters may be applied directly to the display of device. Some external accessories may limit the viewing angle of the screen, so that only users directly in front of the screen can see the contents displayed on the screen, while those at oblique angles will see a darkened or obscured display. In some examples, the privacy mode may be implemented based on polarized plastic sheets that can be attached to the screen using adhesive or magnetic strips. Another way of implementing the privacy mode may involve clip-on privacy filters, which may be easily removed or reapplied as needed. These privacy solutions may be used in corporate environments or public settings like coffee shops and airplanes, where users may prefer preventing visual eavesdropping on sensitive data.

These solutions may require constant manual application and removal, which can be cumbersome, especially for mobile users who frequently switch between private and collaborative work environments.

Another disadvantage may be the fixed nature of these filters. It may make it difficult to switch between private and collaborative modes without physically removing the filter. Additionally, privacy screens may often cause a reduction in brightness and color clarity, leading to suboptimal viewing experiences in normal usage. It can also make it difficult to clean the screen or introduce glare when used in high-ambient light conditions.

Overall, while these solutions provide basic privacy protection, they lack flexibility and degrade the overall user experience in some scenarios including one where collaboration or screen-sharing is required.

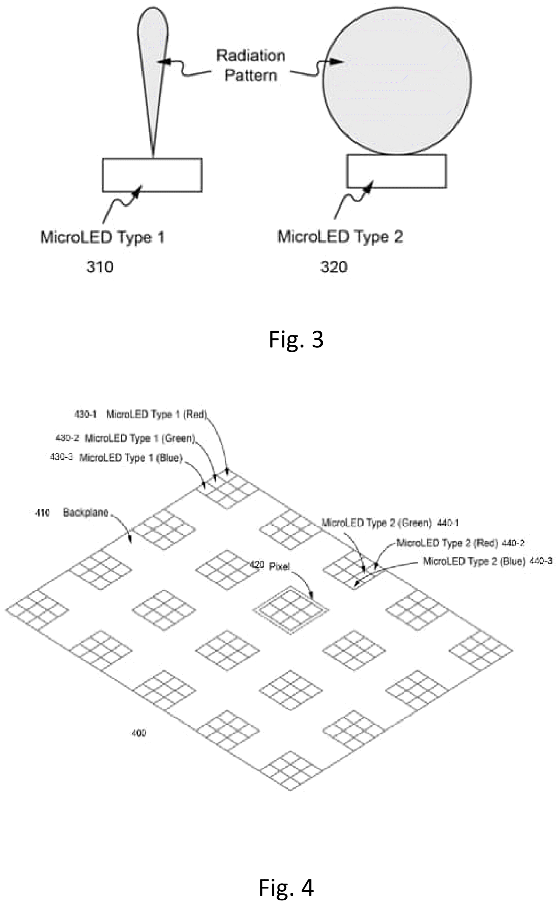

Fig. 3 illustrates Type 1 and Type 2 MicroLED emitters of an example.

In some examples, a display apparatus and a method for its fabrication are provided. The display apparatus may be for use in laptops, smartphones, and tablets, and may enable the user to seamlessly switch between private and collaborative modes. The display apparatus may be based on a pixel structure, where each pixel includes two distinct types of MicroLED emitters, referred to as Type 1 MicroLED emitter 310 and Type 2 MicroLED emitter 320. In some examples, a Type 1 MicroLED emitter may also be called MicroLED Type 1. The same reference may also be applied to Type 2 MicroLED emitters.

Fig. 4 illustrates a portion of a display 400 including different types of LED emitters of an example.

The portion of the display may include a backplane 410, and a plurality of pixels 420 formed on backplane. The pixel may include a first set 430 including three MicroLED emitters of Type 1 and a second set 440 including three MicroLED emitters of Type 2, where each set is configured to emit the primary colors: red, green, and blue. In a specific example, the first set of Type 1 MicroLED emitters 430-1 to 430-3 may include a red emitter at 630 nm, a green emitter at 532 nm, and a blue emitter at 467 nm. Similarly, the second set of Type 2 MicroLED emitters 440-1 to 440-3 may feature the same emission wavelengths for red, green, and blue. It is noted that the first set of Type 1 MicroLED emitters 430 and the second set of Type 2 MicroLED emitters 440 may be included in one same pixel. In some examples, each or some of the pixels on display 400 include both the first set of Type 1 MicroLED emitters 430 and the second set of Type 2 MicroLED emitters 440.

In some examples, the two sets of emitters have different distinct radiation patterns. For example, Type 1 MicroLED emitters may have a super-Lambertian radiation pattern, exhibiting a relatively narrow divergence angle of approximately 30 degrees. The divergence angle may be also called emission angle in some examples. This limited viewing angle is preferred for the private mode, as it reduces visibility for anyone not directly in front of the screen, preventing visual eavesdropping and enhancing privacy. On the other hand, Type 2 MicroLED emitters may have a Lambertian radiation pattern with a wider divergence angle of approximately 120 degrees. The wider divergence angle allows for broader visibility and makes the Type 2 emitters suitable for collaborative mode, where the user may want to share the screen's content with others.

The user can switch between these two modes, private and collaborative, by activating either the Type 1 or Type 2 MicroLED emitters. A simple control mechanism, such as a button integrated into the display apparatus, is provided to facilitate this transition. When the user presses the button, the display switches between utilizing the super-Lambertian Type 1 emitters for privacy mode and the Lambertian Type 2 emitters for collaborative mode. This design enables seamless switching without requiring any external privacy filters or accessories, offering a more integrated, flexible, and user-friendly solution.

The disclosed method for making the display involves precise fabrication of both sets of MicroLEDs, ensuring their specific emission characteristics and radiation patterns are achieved for optimal performance in both private and collaborative modes. This aspect provides a significant improvement over other privacy screens, offering enhanced functionality and user experience.

Some solutions in the above examples may provide a seamless way to transition between different display modes, integrating privacy filters and wide-view technologies into the device's screen and improving both individual productivity and group interaction without compromising ease of use or requiring additional hardware. This dual-mode functionality may address the growing demand for both privacy and collaboration in different type of devices.

In some examples, the emitters are MicroLED emitters, some other types of LED emitters or some non-LED emitters.

In some examples, a nanostructured n-type gallium nitride (GaN) Distributed Bragg Reflector (DBR) may be used to manufacture the MicroLED Type 1 emitter 430. The use of the DBR may leverage nano-porosity to achieve good performance in optical applications. A DBR may function as a highly reflective mirror through alternating layers of materials with different refractive indices. In this case, the n-type GaN DBR may be engineered with nano-sized pores, allowing for fine-tuning of its refractive index by controlling the porosity level. This may offer several advantages over DBR designs for devices like MicroLED displays, lasers, and photodetectors.

In some examples, MicroLED (µLED) display is a type of display technology that uses a matrix of individually switched self-illuminating inorganic diodes that can be controlled and lit without a master backlight. Inorganic MicroLEDs have a number of potential advantages over organic LEDs (OLEDs) for display applications, such as the possibility of high brightness.

In some examples, a MicroLED display is similar in architecture to an OLED display. They are both emissive displays where the display is made of a two-dimensional array of pixels. Each pixel may include at least three microscopic size light emitters, such as light emitting diodes or LEDs, that are controlled by electronic circuits for each pixel. For RGB (red, green, and blue) displays, the three emitters produce red, green, and blue lights with different intensities so that the mixing of the three emissions produce a specific color according to the image to be displayed. The image data may be provided to the 2D array of pixels from data drivers along the columns of the 2D array. A particular pixel may be enabled using row scanning signals provided by scan drivers external to the 2D pixel array.

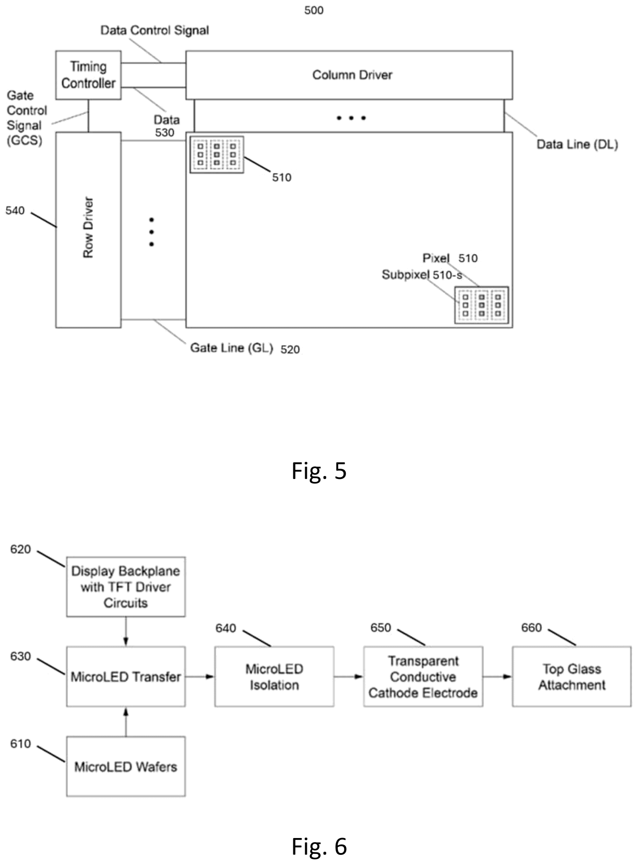

Fig. 5 illustrates an architecture of a MicroLED display 500 of an example. The MicroLED display shows a 2D array of pixels 510. One or more gate lines 520 may select a row, and a column line may provide image data 530 to the pixels 510. The pixels in Fig. 5 may comprise three subpixels 510-s, where each subpixel 510-s may include three emitters 510-e that are coupled with a pixel driver circuit. The pixel driver circuit may be enabled by row drivers 540 and image data may be provided from the column drivers 540

In some examples, a MicroLED display device or apparatus may be implemented by growing MicroLEDs on a sapphire or silicon substrate, removing the MicroLED from the sapphire or silicon substrate, and transferring the removed MicroLED to a transistor substrate, which is also known as a display backplane.

Fig. 6 illustrates a diagram of manufacturing MicroLED displays of an example. As illustrated in Fig. 6, three MicroLED wafers and a display plane with TFT driver circuits are provided to a MicroLED transfer equipment that will transfer MicroLEDs onto a display backplane at 610 and 620. Among the three MicroLED wafers, one is for red MicroLEDs, one is for green MicroLEDs, and one is for blue MicroLEDs. The display backplane may include pixel driving circuits that are made of thin film transistors (TFTs) on glass substrate. After the transfer at 630, an insulating layer is deposited, exposing the top electrode, e.g., cathode, of the MicroLEDs at 640. Then, a transparent conducting oxide may be deposited to act as a common cathode at 650. After that, a top glass protection is attached at 660.

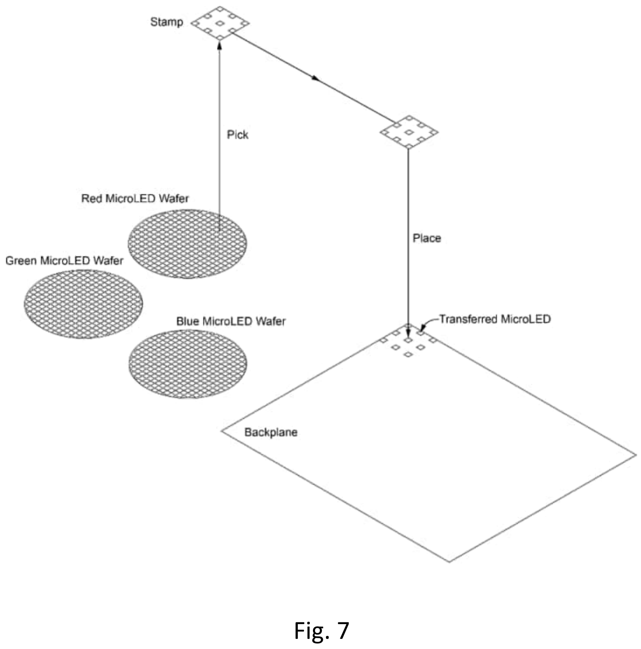

Fig. 7 illustrates a diagram of pick-and-place (PnP) transfer of an example. As illustrated by Fig.7, three wafers for red, green, and blue emitting MicroLEDs are provided. After that, a stamp that is equipped to pick up the MicroLEDs from each wafer and then place the MicroLEDs on the backplane is used to transfer the MicroLEDs. The sequential movement of the stamp between the wafer and the backplane may be used to expand the size of the display.

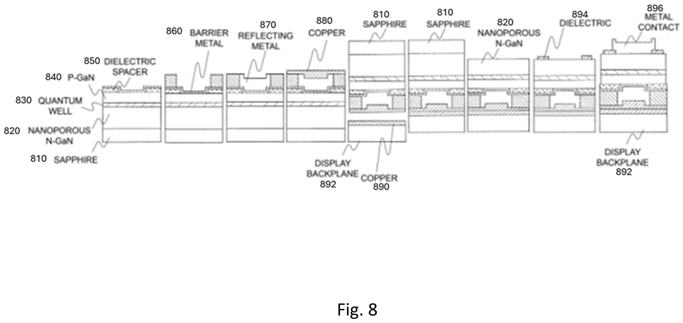

Fig. 8 illustrates manufacturing of an emitter with a narrow emission angle of an example.

As illustrated in Fig. 8, the manufacturing of the emitter may start with making a planar MicroLED. In some examples, the planar MicroLED may include a sapphire substrate 810, one or more nanoporous layers 820, multiple quantum wells 830, a p-type GaN layer 840 and a dielectric spacer 850.

During the making the planar MicroLED, a thin aluminum nitride buffer layer (e.g. using sputtering or Metal-Organic Chemical Vapor Deposition (MOCVD) epitaxy) may be deposited on the sapphire substrate 810 in some examples. Furthermore, an undoped GaN buffer layer of thickness of 1-4um, an n-type GaN layer of thickness of 0.5-1um, and a nanoporous GaN DBR stack may be grown.

In some examples, the one or more nanoporous layers 820 may be formed by performing electrochemical etching of the n-GaN layers in the nanoporous GaN DBR stack. One or more quantum wells 830 may be grown on the one or more nanoporous layers 820. where each quantum well comprises a thin InGaN active layer that is sandwiched between two doped or undoped GaN barrier layers. The InGaN active layer may have a thickness of 1-5nm and indium mole fraction of 20%. On top of the last quantum barrier GaN layer, a thin AlGaN layer may be deposited as an electron barrier layer. The thickness of the thin AlGaN layer may be in the range of 1-20 nm. In some examples, a p-type GaN layer 840 may be further grown on the one or more quantum wells 830. The thickness of the p-type GaN layer 840 may be 0.5-1 um in some examples. In order to activate the magnesium doping in the p-type GaN, thermal annealing may be further implemented in the planar MicroLED. In some examples, the dielectric spacer 850 may be deposited on top of the p-type GaN layer followed by patterning to define an aperture.

After the planar MicroLED is made, barrier metal 860 may be deposited on it. On the barrier metal 860, reflecting metal 870 may be further deposited, where the deposition may be by electroplating or sputtering. After reflecting metal 870 is deposited, bonding metal 880 may be deposited. The bonding metal may be copper in some examples. Furthermore, chemical mechanical polishing (CMP) may be to planarize the smooth surface of the bonding metal 880. In a further operation, the surface of the bonding metal 880 may be flip-chipped and aligned with another surface 890 formed on a display backplane 892. After the two surfaces 880 and 890 are flip-chipped and aligned, they are bound together. Different bonding techniques, such as room temperature direct fusion bonding or thermal compression bonding (TCB) at low temperature, may be used to implement the bonding. The low temperature may be <200°C or <1800°C. In some examples, other bonding methods, such as using solder, may be implemented as well. In some examples, the two surfaces are smooth copper films.

After the bonding, sapphire 810 may be removed from the Nanoporous N-GaN 820 and then a thin insulating dielectric 894 may be deposited on the top of the Nanoporous N-GaN 820.In some examples, the dielectric 894 is deposited on a smooth surface of the Nanoporous N-GaN, which is also called the n-type GaN layer, 820. Furthermore, one or more apertures may be patterned on dielectric 894 for making a metal contact to the n-type GaN layer 820. In some examples, the dielectric may be silicon nitride or silicon dioxide. In some examples, the n-type GaN layer 820 may act as cathode. In a further operation, metal contact 896 may be deposited on the dielectric 894.

In some examples, the nanostructured nature of the DBR may enhance light control and reflection efficiency, improving the performance of the display apparatus by reducing optical losses. By adjusting the sizes and distributions of the pores within the GaN layers, the refractive index contrast between the alternating layers may be optimized. This increases the reflectivity of the DBR at targeted wavelengths, making it useful for narrow-band reflective applications, such as color-specific MicroLEDs.

Another advantage of the nano-porous n-type GaN DBR may be its compatibility with the existing fabrication processes of GaN-based devices. The new DBR may be integrated seamlessly into a targeted structure, such as an emitter or a display, without introducing significant thermal or mechanical stress, preserving the structural integrity of the backplane.

Furthermore, the porous nature of the DBR in some examples may also enable better thermal management by allowing for improved heat dissipation, which is critical in high-brightness display applications.

Moreover, incorporating nano-porous DBR structures in MicroLED displays, in some examples, may also facilitate the coexistence of the Type 1 and Type 2 MicroLED emitters on the same backplane. It is because the DBR can be tailored to support the specific optical requirements of different emitter types. This enables the seamless transition between private and collaborative modes, while maintaining high display brightness and efficiency.

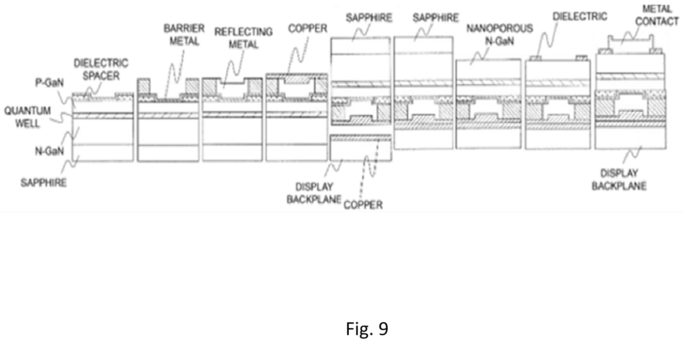

Fig. 9 illustrates structures of a plurality stages of an emitter with a broad emission angle of an example. The emitter with a broad emission angle may be realized using a conventional Micro LED structure. In some examples, the emitter may be the MicroLED Type 2 emitter 440.

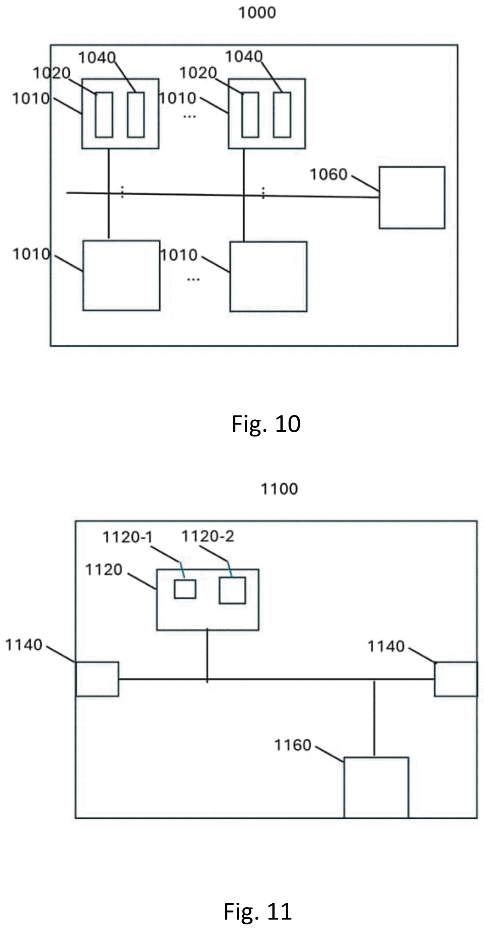

Fig. 10 illustrates a block diagram of a display apparatus 1000 of an example.

In some examples, the display apparatus 1000 may be the display apparatus 400 and the display apparatus 400, 1000 may include a first light emitting structure 430, 1020 of a pixel and a second light emitting structure 440, 1040 of the same pixel 1010. The first light emitting structure 430, 1020 may be configured to emit narrow light suitable for a first display mode, such as private mode, narrow-view mode, or energy-saving mode, while the second light emitting structure 440, 1040 may be configured to emit wide light for a second display mode, such as collaborative mode, broad-view mode, high-performance mode. The emission angle of the narrow light may be smaller than the emission angle of the wide light, enabling the display to function in both privacy-oriented and shared viewing environments. Based on the two types of light emitting structures with different emission angles, the display apparatus 400, 1000 may provide different display modes for different scenarios, adapting to the environment flexibly.

In some examples, the private mode may mean that a display emits light within a narrow emission angle, which may be also known as or result in a narrow viewing angle, achieving that only the user or users in front can see the content on the display. This mode enhances privacy and security, making it ideal for personal use in applications like banking, confidential work, or mobile devices. The cooperative mode may mean that a display emits light over a wider emission angle, also known as viewing angle, allowing multiple viewers in a broad range or scope in front of the display to see the content simultaneously. This mode may be suited for collaborative work, presentations, or entertainment, enabling shared viewing experiences.

The first light emitting structure may emit light (e.g. called narrow light) having a first emission angle. In some examples, the first emission angle may be at most 40° (or at most 20°, or at most 30° or at most 50°) and/or at least 3° (or at least 5° or at least 10° or at least 20°), effectively limiting visibility to users directly in front of the display. This characteristic may be particularly useful in public spaces, where privacy may be essential to prevent unauthorized viewing of sensitive information. The second light emitting structure may emit light (e.g. called wide light) having a second emission angle. **In** some examples, the second emission angle may be at least 100° (or at least 90°, or at last 110°, or at least 120°, or at least 130°), allowing for broader viewing angles that facilitate content sharing in settings such as meetings, presentations, or collaborative tasks. The emission angle of a light emitting structure may be an angle covering 90% or at least 90% of the light emitted by the light emitting structure.

The first light emitting structure and/or the second light emitting structure may be an inorganic light emitting diode, a micro light emitting structure (e.g. a MicroLED), or an organic light emitting diode. **In** some examples, the first light emitting structure may be the MicroLED Type 1 310 and the second light emitting structure may be the MicroLED Type 1 320, where the radiation pattern of Type 1 310 is narrower than the radiation pattern of Type 2 320. The adoption of MicroLED Type 1 310 and MicroLED Type 1 320 may make each display mode have good performance. Both the first and second light emitting structures in some examples may include at least three emitters, such as MicroLED 430-1, 430-2, 430-3, 440-1, 440-2 and 440-3, each configured to emit one of the primary colors: red, green, and blue. This may enable that both display modes maintain full-color fidelity. **In** some examples, each light emitting may include even one or two colors, either primary or not, for some special requirements. The adoption of different colors may make the display to be more flexible with respect to different requirements on colors.

**In** some examples, the first light emitting structure may function as a first sub-pixel, and the second light emitting structure may function as a second sub-pixel, allowing each mode to have a fine and accurate display at the pixel level.

Although MicroLED 430-1, 430-2, 430-3 and MicroLED 440-1, 440-2 and 440-3 in Fig. 4 are not in one same pixel, one pixel may include both of these two types of emitters. In some examples, each emitter may be a pixel in Fig. 4, simplifying the control of the colors. In some examples, the MicroLEDs may be replaced with other types of LEDs, such as Mini-LEDs or Organic Light emitting Diodes (OLED)s, and accordingly MicroLED 430-1, 430-2 and 430-3, and MicroLED 440-1, 440-2 and 440-3 will be replaced with Mini-LED 430-1, 430-2 and 430-3, and Mini-LED 440-1, 440-2 and 440-3, or OLED 430-1, 430-2 and 430-3, and OLED 440-1, 440-2 and 440-3. A Mini-LED may refer to an LED made using one or more LED chips smaller than other LED chips. The Mini-LED may produce the same brightness as a larger chip. In some examples, Mini-LEDs may greatly increase the density, emit more light from each unit, and provide even more precise light control than other LED.

To enhance optical performance, the first light emitting structure may include a nanostructured n-type gallium nitride (GaN) reflector. In certain embodiments, this reflector may include pores with a maximal dimension of less than 10 nm, less than 30 nm, less than 50 nm, less than 70 nm or less than 100 nm, enabling precise light manipulation and reflection control. In some implementations, the reflector may be a Distributed Bragg Reflector (DBR), which may include alternating layers of materials with different refractive indices to improve reflectivity and efficiency.

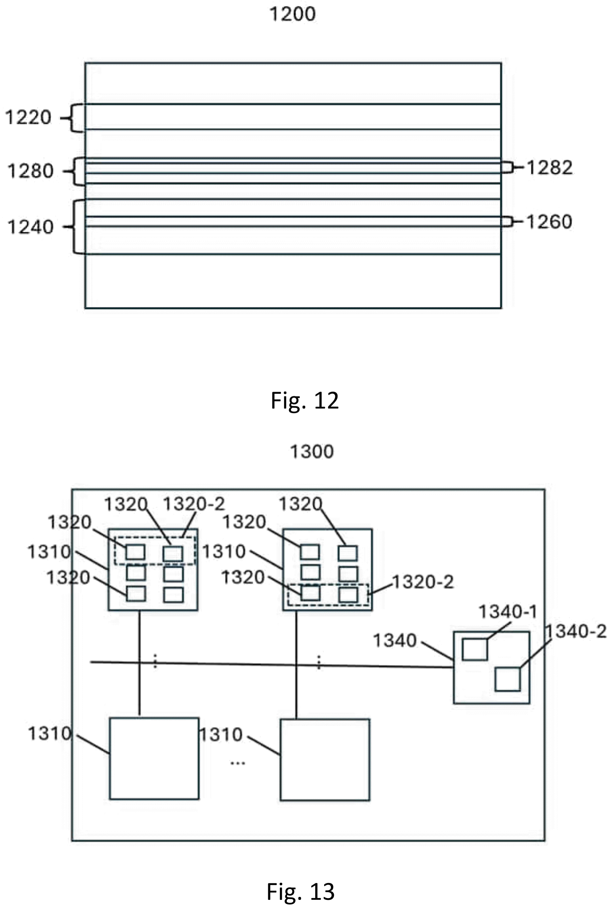

In some examples, the first light emitting structure may be manufactured as illustrated by Fig. 8, which includes a sapphire substrate 810, one or more nanoporous layers 820, also called nanostructured n-type gallium nitride (GaN) reflector, multiple quantum wells 830, a p-type GaN layer 840, a dielectric spacer 850, barrier metal 860, reflecting metal 870, bonding metal 880, surface 890 formed on a display backplane 892, dielectric 894 and metal contact 896. The first light emitting structure may be implemented as described in connection with Fig. 12.

To allow users to seamlessly switch between display modes, the display apparatus may further include control circuitry 1060 that may selectively activate either the first light emitting structure for private mode or the second light emitting structure for collaborative mode. The control circuitry 1060 in some may include at least one of a physical button or a software-based interface, ensuring user-friendly interaction. By simply pressing a button or activating software control, users may switch between private and collaborative modes, without the need for external privacy screens or physical screen adjustments.

These examples may present an improvement over other privacy screens, which may require manual application and removal of external filters, often leading to reduced screen clarity, cumbersome handling, and limited flexibility. By integrating two distinct light emitting structures within the same pixel, the proposed display apparatus may enhance both individual productivity and collaborative interactions.

In some examples, the first LED structure may be fabricated using a nanostructured n-type GaN reflector, designed to achieve narrow light emission for private mode. The manufacturing process may include electrochemical etching of the n-GaN layers in a nanoporous GaN DBR stack, achieving precise control over the emission angle. Additionally, a thin insulating dielectric layer, such as silicon nitride or silicon dioxide, may be deposited to enhance electrical and optical performance. The cathode metal contact may then be patterned to establish an electrical connection to the n-type GaN layer, enabling efficient power delivery to the MicroLED structures.

By incorporating these features, the display apparatus 1000 may seamlessly integrate privacy and collaboration functions into a single device, making it valuable for laptops, smartphones, tablets, and other mobile displays. The ability to switch between narrow and wide emission angles using built-in light emitting structures may offer a superior alternative to other privacy screens, making this technology well-suited for business professionals, public users, and content-sharing applications.

More details and aspects are mentioned in connection with the embodiments described above or below. The example shown in Fig. 10 may comprise one or more optional additional features corresponding to one or more aspects mentioned in connection with the proposed concept or one or more examples described above (e.g. Fig. 1-9) or below (e.g. Fig. 11-17).

Fig. 11 illustrates a block diagram of a display apparatus 1100 of an example. The apparatus 1100 may include processing circuitry 1120 configured to generate a control signal for triggering a light emission of a first sub-pixel of a pixel in a first display mode and triggering a light emission of a second sub-pixel of the pixel in a second display mode. The apparatus 1100 may further include an output interface 1140 for providing the control signal to a display, enabling dynamic switching between different viewing modes based on user preferences and environmental conditions, both protecting privacy and conveniently sharing the screen.

The first display mode may be a privacy mode, a narrow-view mode, or a energy-saving mode, and the second display mode may be a cooperative mode, a broad-view mode, or a high-performance mode. When the privacy of a user needs protection, the processing circuitry 1120 may generate a control signal for triggering the light emission of the first sub-pixel. In order to achieve the privacy mode, the light emission of the second sub-pixel may be depressed. Therefore, the control signal for achieving the privacy mode may control a depression of the light emission of the second sub-pixel. Some examples of depressing the light emission of the second sub-pixel may include turning off the light emission of the second sub-pixel, lowering the light emission of the second sub-pixel to less than 10% or less than 20% of a maximal light emission of the second sub-pixel and/or keeping the second sub-pixel in an un-triggerable state for a time period. Similarly, when the user needs to use the display in the cooperative mode, the processing circuitry 1120 may generate a control signal for triggering the light emission of the second sub-pixel. In order to save energy or limit the brightness of the screen even for all the viewers in the cooperative mode, the control signal may further control a depression of the light emission of the first sub-pixel.

**In** some examples, the control signal may be used to control a plurality of sub-pixels or each sub-pixel on a display to make the first display mode and/or the second display mode to show the images clearly. The control signal may trigger turning off the second sub-pixel or lowering the light emission of the second sub-pixel in the first display mode. The control signal may trigger turning off the first sub-pixel or lowering the light emission of the first sub-pixel in the second display mode or may trigger a light emission of the first sub-pixel and the second sub-pixel in the second display mode (e.g. to increase the brightness).

**In** some examples, the triggering may be implemented by sending a control signal directly to the pixel, instructing the pixel of turning on or illuminating the first sub-pixel and/or the second sub-pixel. **In** some examples, the triggering may be implemented by sending a control signal sent to a controller separate from the pixel, instructing the controller of turning on or illuminating the first sub-pixel and/or the second sub-pixel.

**In** some examples, the processing circuitry 1120 may be configured to adjust the intensity of light emission of the first sub-pixel in the first display mode based on a privacy level setting. This privacy level setting may be determined by at least one of a user input or an environmental condition. For example, when a user requires increased privacy, the processing circuitry may reduce the brightness of the first sub-pixel, further limiting visibility for bystanders. **In** contrast, when the privacy level setting indicates a lower privacy requirement, the light intensity of the first sub-pixel may be adjusted to a higher level to optimize the viewing experience. Based on the adjustment of the intensity, the privacy may be protected better.

In some examples, the processing circuitry 1120 may include a processor 1120-1 and a memory 1120-2 storing computer-readable instructions. When the computer-readable instructions are performed or implemented by the processor 1120-1, the processor 1120-1 performs or enables the processing circuitry 1120 to perform the operations of the processing circuitry 1120. When the instructions are changed, the operations that the processor or the processing circuitry may perform will change accordingly. In some examples, the processing circuitry 1120 may be General Purpose CPUs, Mobile Processors, Server and Data Center Processors, Embedded Processors, Graphics Processing Units (GPUs), Specialized Processors, Microcontrollers, Field-Programmable Gate Arrays (FPGAs), Digital Signal Processors (DSPs), application-specific integrated circuits (ASICs), integrated circuits (ICs) and/or other circuitries having the capability of performing the operations of the controller in each and every example of this disclosure. In some examples, the memory 1120-2 may be RAM, DRAM, Double-Data-Rate DRAM (DDR-DRAM), SDRAM, static RAM (SRAM), ROM, programmable ROM (PROM), erasable programmable ROM (EPROM), electrically erasable programmable ROM (EEPROM), Compact Disk ROM (CD-ROM), Compact Disk Recordable (CD-R), Compact Disk Rewriteable (CD-RW), flash memory (e.g., NOR or NAND flash memory), content addressable memory (CAM), polymer memory, phase-change memory, ferroelectric memory, silicon-oxide-nitride-oxide-silicon (SONOS) memory, a disk, a floppy disk, a hard drive, an optical disk, a magnetic disk, a card, a magnetic card, an optical card, a tape, a cassette, and the like.

To facilitate user control, the apparatus may include at least one of a button or a software-based interface, which may be configured to transmit an instruction to the processing circuitry. This functionality may enable seamless interaction, allowing users to manually switch between the first display mode, such as a private mode, and the second display mode, such as a collaborative mode. Additionally, the apparatus may include a sensor 1160 configured to detect a triggering event for display mode switching.

The triggering event may include at least one of a user gesture or a change in the number of viewers within a predefined field of view of the display. For example, if a sensor detects that multiple users may be present near the display, the apparatus may automatically switch from the first display mode (private mode) to the second display mode (collaborative mode), providing a more inclusive viewing experience. Conversely, when the sensor may detect that a user may be alone, the private mode may be activated, limiting the screen's visibility to the primary viewer.

In some examples, the sensor 1160 for display mode switching could be a proximity sensor to detect user distance, a camera with Al-based face detection to recognize the number of viewers, or an infrared (IR) sensor to sense body heat signatures. Additionally, a Time-of-Flight (ToF) sensor can measure depth and movement for gesture control, while an ambient light sensor adjusts brightness based on lighting conditions. A touch or motion sensor may also enable manual gestures for seamless mode switching between private and collaborative viewing.

**In** some examples, the processing circuitry 1120 may further generate an additional control signal for triggering a light emission of a third sub-pixel of the pixel to improve the overall display.. The third sub-pixel may be of a certain display mode, either the first one or the second one. In some examples, the third sub-pixel be of a third display mode which may be combined with the first display mode or the second display mode. When the processing circuitry 1120 determines that the first display mode is to be strengthened, it may send a control signal for triggering a light emission of a sub-pixel of the first display mode. Similarly, when the processing circuitry 1120 determines that the second display mode is to be strengthened, it may send a control signal for triggering a light emission of a sub-pixel of the second display mode. When the processing circuitry 1120 determines an additional visual effect is needed for the first or second display mode, it may send a control signal for triggering a light emission of a sub-pixel enabling the additional visual effect. This may allow for precise adjustments, ensuring that display quality may be optimized based on viewing conditions. By dynamically managing the activation and brightness of the first, second, and third sub-pixels, the apparatus may enhance the overall display performance, offering seamless transitions between display modes while maintaining high image quality. **In** some examples, the first, second, and third sub-pixels may be extended to first, second and third groups of sub-pixels, obtaining better display using more sub-pixels.

**In** some examples, the output interface may be a Display Interface Engine (DIE), a Serial Peripheral Interface (SPI), a DisplayPort (DP), or a HyperTransport (HT).

**In** some examples, the apparatus may work in conjunction with a display system, such as display apparatus 400, 1000, where each of some or all pixels may include a first light emitting structure for the first display mode and a second light emitting structure for the second display mode. The first light emitting structure may have a first emission angle, which may be at most 40° (or at most 20°, or at most 30° or at most 50°) and/or at least 5° (or at least 10° or at least 20°), while the second light emitting structure may have a second emission angle of at least 100, 110 or 120 degrees, achieving effective privacy control and collaboration functionality. The light emitting structures may include distinct MicroLEDs, Mini-LEDs or OLEDs, which may be designed to optimize narrow and wide light emission.

By integrating processing circuitry, control interfaces, and sensors, the apparatus may provide a flexible and intelligent display solution that may eliminate the need for external privacy screens while offering a seamless user experience. This solution may be beneficial in devices such as laptops, smartphones, and tablets, enabling users to switch between privacy and collaborative modes dynamically based on user preferences and environmental conditions.

More details and aspects are mentioned in connection with the embodiments described above or below. The example shown in Fig. 11 may comprise one or more optional additional features corresponding to one or more aspects mentioned in connection with the proposed concept or one or more examples described above (e.g. Fig. 1-10) or below (e.g. Fig. 12-17).

Fig. 12 illustrates a block diagram of a light emitter 1200 of an example.

In some examples, a light emitter 1200, which may be the light emitting structure 430 or the structure illustrated by Fig. 8, may include a p-type gallium nitride (GaN) layer 1220, 840 and a nanostructured n-type gallium nitride reflector 1240, 820 having a plurality of pores with a maximal dimension of less than 10, less than 30, less than 50, less than 70 or less than100 nm. In some examples, the layer 1220 may be the layer 840, and the reflector 1240 may be the reflector 820. The nanostructured n-type GaN reflector 1240, 820 may be designed to enhance light reflection, thereby improving the efficiency of light extraction in display applications.

In some examples, the nanostructured n-type GaN reflector 1240, 820 may be a high-reflectivity structure made from n-type GaN with engineered nanostructures to enhance optical performance. It may include a Distributed Bragg Reflector (DBR) structure 1260, which may be formed by alternating layers of materials with different refractive indices. In some examples, a DBR is a multilayer structure made of alternating high and low refractive index materials, designed to reflect specific wavelengths of light based on Bragg reflection. By ensuring each layer's optical thickness is λ/4 of the target wavelength, DBRs achieve high reflectivity (>99%) and are widely used in LEDs, VCSELs, optical filters, and photonic devices to enhance light extraction and waveguiding. The use of a DBR structure may optimize the reflection of emitted light, ensuring that a significant portion of the generated photons may be directed toward the light extraction surface, thereby increasing display brightness and efficiency.

The light emitter 1200 may further include an active region 1280 disposed between the p-type gallium nitride layer 1220 and the nanostructured n-type gallium nitride reflector 1240. This active region 1280 may include indium gallium nitride (InGaN), which may be a direct bandgap semiconductor made of indium, gallium, and nitrogen, widely used in LEDs, lasers, and photonic devices. Its tunable bandgap (0.7-3.4 eV) allows emission across a broad spectrum, making it essential for blue, green, and white LEDs in displays and lighting application. The InGaN in the active region may be responsible for the generation of photons when an electrical current may be applied. In some examples, the active region may include one or more quantum wells 1282, 830, which may enhance carrier confinement and improve light emission efficiency. The quantum wells 1282, 830 may be designed with specific thickness and indium composition to achieve desired emission wavelengths, such as red, green, or blue for LED displays, such as MicroLED displays.

The nanostructured n-type GaN reflector 1240 may be configured to reflect light emitted from the active region 1280 towards the light extraction surface. This reflection mechanism may help minimize light loss and ensure that a greater proportion of emitted light may be extracted from the device, improving luminance and overall energy efficiency. In some examples, the pores within the nanostructured reflector 1240 may be formed in a periodic pattern, which may enable precise control over optical properties, enhancing the reflection and interference effects of the emitted light.

To improve electrical conductivity while maintaining optical transparency, the light emitter 1200 may include a transparent conductive layer formed over the p-type gallium nitride layer. This layer may be designed to uniformly distribute current across the emission area while allowing maximum light transmission toward the extraction surface. Examples of transparent conductive layers may include indium tin oxide (ITO) or other transparent conductive oxides (TCOs).

The light emitter may be configured for use in a LED display, where it may function as an individual pixel or sub-pixel, forming part of a high-resolution, self-emissive display matrix. In some examples, the LED display may be a MicroLED display, a Mini-LED display or a OLED display. The integration of a nanostructured reflector within the light emitter may enhance light output efficiency, making it well-suited for energy-efficient, high-performance displays.

In some examples, the light emitter may further include a passivation layer covering at least a portion of the nanostructured n-type gallium nitride reflector. The passivation layer may help protect the nanostructured reflector from environmental degradation, including oxidation and contamination, while also reducing surface recombination effects that may negatively impact device efficiency. The passivation layer may be formed using materials such as silicon nitride (Si₃N₄) or silicon dioxide (SiO₂), both of which may provide excellent electrical insulation and surface stability.

By incorporating these design elements, the light emitter may provide a high-efficiency solution for LED displays, ensuring optimized light emission, improved energy efficiency, and enhanced device reliability. The use of nanostructured GaN reflectors, quantum wells, and transparent conductive layers may enable next-generation display technologies that may offer superior visual performance and durability in applications such as smartphones, tablets, televisions, and augmented reality (AR) devices.

More details and aspects are mentioned in connection with the embodiments described above or below. The example shown in Fig.12 may comprise one or more optional additional features corresponding to one or more aspects mentioned in connection with the proposed concept or one or more examples described above (e.g. Fig. 1-11) or below (e.g. Fig. 13-17).

Fig. 13 illustrates a block diagram of a display apparatus 1300 of an example. The display apparatus 1300 may apply reverse bias to a first subset of the light emitters in the display apparatus 1300 to perform light detection. Based on the reverse bias, the display apparatus 1300 may enable the light emitters, which may be used for emitting lights, work as a photodetector, reducing the cost or complexity of configuring an external photodetector to the display apparatus.

In some examples, the display apparatus 1300, which may be the same to apparatus 200, may include a plurality of light emitters 1320, and processing circuitry 1340 configured to apply reverse bias to a first subset 1320-2 of the light emitters 1320 to perform light detection. In some examples, the first subset 1320-2 of the light emitters may be LED emitters, such as emitters in the MicroLED 210-2. In some examples, the plurality of light emitters 1320 are included in one or more pixels 1310. In some examples, each pixel 1310 may include a first subset 1320-2. In some examples, some of all pixels respectively have a first subset 1320-2. As lighter emitters may function as light detectors, the need of additional light detectors is reduced and therefore the structure of the display apparatus may be simplified.

In some examples, an emitter may include a photodiode, and therefore a reverse-biased emitter may include a reverse-biased emitter, such as a reverse-biased LED. The reverse-biased emitter may be used to detect light or photo. When light strikes the photodiode, a photocurrent may be generated. Based on the generated photocurrent, the light may be detected. Thin-Film Transistors (TFTs), such as Indium Gallium Zinc Oxide (IGZO) or Low-Temperature Polycrystalline Silicon (LTPS) TFTs, may be used to control and amplify the electrical signals generated by a photodiode. TFTs may be included in the processing circuitry 1340. In some examples, the detected photocurrent is weak. Therefore, TFTs may amplify the detected photocurrent, so that the detection of photo or brightness will be more accurate.

In some examples, processing circuitry 1340 may further include photodetector circuitry and LED driver circuitry, sharing power lines and/or control signals. The sharing may reduce interconnect complexity and enable seamless interaction between light sensing and display driving functions.

In some examples, a LED being used as a photodetector may be a quantum well-based LED, which may leverage the properties of the quantum well structure under reverse bias conditions. In some examples associated with MicroLED design, the quantum well may be formed from a 5nm InGaN layer sandwiched between two 12nm un-doped GaN quantum barriers.

In some examples, the reverse bias to the LED may make one or more depletion regions in the LED to extend across the p-n junction and into the quantum well, creating a strong electric field. This field may separate any photo-generated electron-hole pairs when photons strike the device, such as in the InGaN quantum well. The photon absorption may be maximized or increased due to a narrower bandgap of InGaN in the quantum well.

In some examples, the reverse bias may refer to applying a voltage in an opposite direction to its normal operation, where the positive terminal of the power source is connected to the cathode (-) and the negative terminal is connected to the anode (+).

In some examples, some light emitters 1320 may function as both light emitting and light-detecting elements at different time slots, enabling an efficient and integrated method for adaptive display control. The processing circuitry 1340 may be configured to selectively switch between applying forward bias for light emission and applying reverse bias for light detection to the first subset of light emitters. This capability may allow the display to dynamically alternate between emitting light and detecting ambient light, contributing to features such as adaptive brightness control, proximity detection, and ambient light sensing. The processing circuitry may also apply different reverse bias voltages to different subsets of light emitters, enabling variable sensitivity for different light detection applications.

To optimize ambient light sensing, the processing circuitry 1340 may be configured to adjust the intensity of the reverse bias applied to the first subset of light emitters in response to changes in ambient light intensity. For example, in a bright environment, the reverse bias voltage may be increased to improve light detection sensitivity. Additionally, the processing circuitry may use the light detection data to adjust display brightness, ensuring that the display output remains comfortable for the user and energy-efficient. **In** a non-bright environment, such as a dimly lit room or nighttime setting, the reverse bias voltage applied to the photodetector, e.g., reverse-biased LEDs, may be decreased to prevent excessive sensitivity to small light fluctuations and reduce noise. For example, in low-light conditions, the display may detect the reduced ambient light and automatically lower its brightness to prevent glare and eye strain. Additionally, reducing the reverse bias voltage helps conserve power while still maintaining adequate light detection for functions like proximity sensing or adaptive brightness control.

The processing circuitry 1340 may be configured to apply reverse bias to the first subset 1320-2 of the light emitters 1320 to perform light detection and apply forward bias to a first subset of the light emitters 1320 to perform image display. When the processing circuitry 1340 determines that the capability of light detection is to be improved, it may apply reverse bias to a portion of the second subset of the light emitters 1320, converting them from display emitters into photodetection emitters. When the processing circuit 1340 determines that the displaying capability of the display is to be improved, it may apply forward bias to some of the first subset of the light emitters 1320, changing some light emitters from photodetection emitters into display emitters. For example, the processing circuitry 1340 may be configured to compensate for pixel aging by applying forward bias to some light emitters which were reverse biased. The switch between photodetection emitters and display emitters may dynamically balance display and photo detection, optimizing both the visual performance and ambient light detection.

**In** some examples, the displaying capability may be modified by adjusting forward bias voltages. When the displaying capability is to be improved, the processing circuitry 1340 may adjust one or more forward bias voltages to a higher level. When the displaying capability is to be limited, the processing circuitry 1340 may adjust one or more forward bias voltages to a lower level. For example, the processing circuitry 1340 may be configured to compensate for pixel aging by increasing forward bias voltages of some of the light emitters based on pixel aging data determined through light detection. Over time, individual light emitters may degrade, leading to inconsistent brightness levels across the display. By detecting brightness variations due to aging, the processing circuitry may apply compensation to restore uniform brightness and extend the display's lifespan.

To further enhance user interaction, the processing circuitry may be configured to detect a user in proximity based on light detection and adjust display brightness accordingly. In some examples, when the system may detect that a user is near, the display brightness may be increased, ensuring better visibility. Conversely, when no user is detected, the display may automatically dim or turn off, reducing power consumption. The display apparatus may include an array of pixels, where each pixel may include at least one light emitter configured for both light emission and light detection at different time slots, thereby eliminating the need for separate external sensors.

The plurality of light emitters in the display apparatus may be arranged in a matrix pattern, where the first subset of light emitters used for light detection may be periodically distributed across the matrix. This strategic placement may ensure comprehensive ambient light sensing while maintaining a balanced display output.

In some examples, the processing circuitry 1340 may detect external light sources based on light detection and generate a control signal to compensate for glare by adjusting display contrast. This feature may improve readability in high-glare environments by dynamically enhancing contrast.

The processing circuitry 1340 may include a processor 1340-1 and a memory 1340-2 storing computer-readable instructions. When the computer-readable instructions are performed or implemented by the processor 1340-1, the processor 1340-1 performs or enables the processing circuitry 1340 to perform the operations of the processing circuitry 1340. When the instructions are changed, the operations that the processor or the processing circuitry may perform will change accordingly. In some examples, the processing circuitry 1340 may be General Purpose CPUs, Mobile Processors, Server and Data Center Processors, Embedded Processors, Graphics Processing Units (GPUs), Specialized Processors, Microcontrollers, Field-Programmable Gate Arrays (FPGAs), Digital Signal Processors (DSPs), application-specific integrated circuits (ASICs), integrated circuits (ICs) and/or other circuitries having the capability of performing the operations of the controller in each and every example of this disclosure. In some examples, the memory 1340-2 may be RAM, DRAM, Double-Data-Rate DRAM (DDR-DRAM), SDRAM, static RAM (SRAM), ROM, programmable ROM (PROM), erasable programmable ROM (EPROM), electrically erasable programmable ROM (EEPROM), Compact Disk ROM (CD-ROM), Compact Disk Recordable (CD-R), Compact Disk Rewriteable (CD-RW), flash memory (e.g., NOR or NAND flash memory), content addressable memory (CAM), polymer memory, phase-change memory, ferroelectric memory, silicon-oxide-nitride-oxide-silicon (SONOS) memory, a disk, a floppy disk, a hard drive, an optical disk, a magnetic disk, a card, a magnetic card, an optical card, a tape, a cassette, and the like.

By incorporating reverse-biased light emitters for photo-detection, the display apparatus may integrate adaptive brightness control, proximity detection, pixel aging compensation, and glare correction into a single system, reducing reliance on external light sensors. This technology may enable a more cost-efficient, responsive, and power-efficient display, suitable for modern high-resolution applications such as smartphones, tablets, laptops, and automotive displays.

More details and aspects are mentioned in connection with the embodiments described above or below. The example shown in Fig.13 may comprise one or more optional additional features corresponding to one or more aspects mentioned in connection with the proposed concept or one or more examples described above (e.g. Fig. 1-12) or below (e.g. Fig. 13-17).

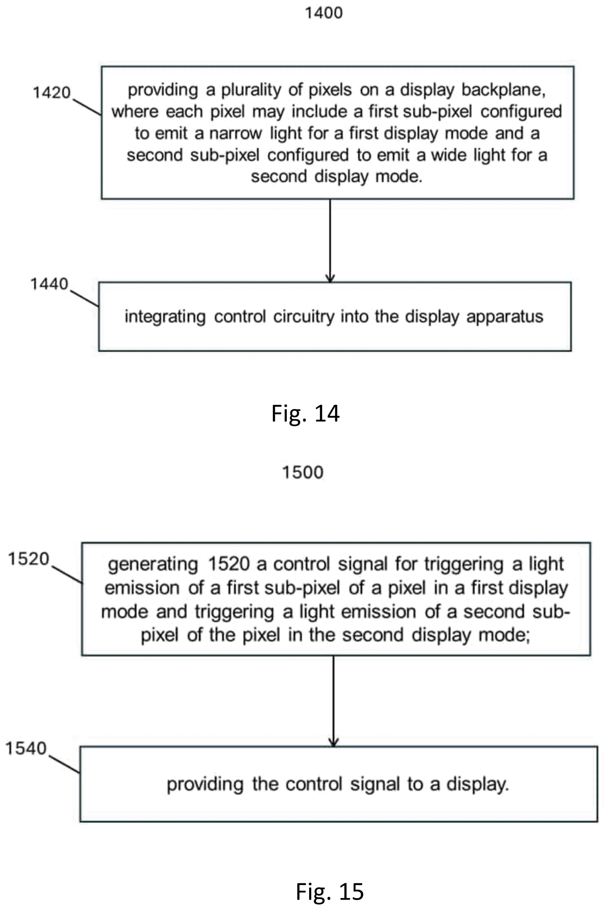

Fig. 14 illustrates a method 1400 of manufacturing a display apparatus of an example.

In some examples, a method 1400 of manufacturing a display apparatus, such as apparatus 1000, may include providing 1420 a plurality of pixels on a display backplane, where each pixel may include a first sub-pixel, such as sub-pixel 1020, configured to emit a narrow light for a first display mode and a second sub-pixel, such as sub-pixel 1040, configured to emit a wide light for a second display mode. The emission angle of the narrow light may be smaller than the emission angle of the wide light, ensuring that the first display mode may enhance privacy, while the second display mode may facilitate content sharing.

In some examples, the method may further include fabricating a nanostructured n-type gallium nitride (GaN) reflector in the first sub-pixel. This nanostructured reflector may improve light reflection, ensuring that emitted light may be more effectively directed towards the desired viewing angle. The nanostructured GaN reflector may be fabricated using nano-porous etching techniques, which may allow precise tuning of reflectivity and emission properties.

To transfer the first and second sub-pixels to the display backplane, the method in some examples may include using a pick-and-place (PnP) technique. This transfer process may ensure accurate positioning of light emitting structures, allowing for high-resolution display fabrication. In some examples, either or both the first sub-pixel and the second sub-pixel may be transferred using this PnP approach, ensuring efficiency and precision in display assembly.

The first light emitting structure may have an emission angle of at most 40 degrees, providing a narrow viewing angle suitable for privacy mode applications. In contrast, the second light emitting structure may have an emission angle of at least 100 degrees, making it suitable for wide-angle viewing in collaborative mode.

Each light emitting structure may include at least three emitters, where the first light emitting structure may emit red, green, and blue light, and the second light emitting structure may include a second type of emitters also configured to emit red, green, and blue light. These emitters may allow full-color image rendering, ensuring seamless transitions between display modes without affecting color accuracy.

The first light emitting structure may be configured as a first sub-pixel, and the second light emitting structure may be configured as a second sub-pixel, allowing for pixel-level mode switching. Additionally, the first and second light emitting structures may be configured as distinct light emitting diode (LED) structures, where the first LED structure and the second LED structure may be two different MicroLED structures. The use of MicroLED technology may enable higher efficiency, better brightness control, and improved display lifetime compared to other LED displays.

In some examples, the method may include forming nano-sized pores on the nanostructured n-type GaN reflector. These nano-sized pores may be arranged in a controlled periodic pattern, optimizing light reflectivity and reducing optical losses. In some examples, the nanostructured reflector may be a Distributed Bragg Reflector (DBR), which may improve the directionality and efficiency of light reflection within the first sub-pixel.

In some examples, the method may further include integrating 1440 control circuitry into the display apparatus, where the control circuitry may be configured to selectively activate either the first light emitting structure for the first display mode or the second light emitting structure for the second display mode. This control mechanism may allow seamless switching between privacy and collaborative modes, ensuring an adaptable display experience. In some other examples, the control circuitry does not need to be integrated into the display apparatus because it can also control the display apparatus when it is located outside.

In some examples, the control circuitry may include at least one of a button or a software-based interface for activating the first or second display mode. This interface may provide users with manual control over display settings, allowing for customized viewing experiences based on user preferences.

By implementing these manufacturing techniques, the display apparatus may enable high-efficiency privacy and collaboration functionalities, making it suitable for laptops, smartphones, tablets, and other modern display applications. The integration of MicroLED technology, nanostructured reflectors, and intelligent control circuitry may enhance image quality, energy efficiency, and user adaptability, ensuring an optimal display solution for various use cases.

More details and aspects are mentioned in connection with the embodiments described above or below. The example shown in Fig. 14 may comprise one or more optional additional features corresponding to one or more aspects mentioned in connection with the proposed concept or one or more examples described above (e.g. Fig. 1-13) or below (e.g. Fig. 15-17).

Fig. 15 illustrates a method 1500 of controlling a display apparatus of an example.

**In** some examples, a method 1500 of controlling a display apparatus may include generating 1520 a control signal for triggering a light emission of a first sub-pixel of a pixel in a first display mode and triggering a light emission of a second sub-pixel of the pixel in the second display mode. The method may further include providing 1540 the control signal to a display, ensuring that the display may dynamically switch between different viewing modes based on user input or environmental conditions.

**In** some examples, the method may further include adjusting the intensity of light emission of the first sub-pixel in the first display mode based on a privacy level setting. The privacy level setting may determine the viewing angle and brightness of the display in privacy mode, ensuring that content may remain visible only to the primary user while preventing unauthorized viewing from side angles. The intensity adjustment may optimize visibility while maintaining a balance between power efficiency and user privacy.

The privacy level setting may be configured based on at least one of a user input or an environmental condition. For example, users may manually select a privacy level, or the display apparatus may automatically adjust the privacy mode based on ambient light conditions. If the environment is bright, the display may increase the intensity of light emission to maintain readability, whereas in low-light environments, the brightness may be reduced to prevent glare while preserving privacy.

To enable seamless display transitions, the method may include detecting a triggering event for switching display modes. The triggering event may include at least one of a user gesture or a change in the number of viewers within a predefined field of view. For example, if a user swipes on the display or moves closer, the display may automatically switch from privacy mode to collaborative mode. Similarly, if the system detects additional viewers nearby, the display mode may be adjusted to a wider viewing angle, allowing multiple users to view content comfortably.

In some examples, the method may further include generating an additional control signal for triggering a light emission of a third sub-pixel of the pixel based on a color calibration setting. This functionality may ensure accurate color reproduction across different display modes, allowing the display apparatus to maintain consistent brightness and color accuracy regardless of changes in viewing conditions.

By incorporating adaptive control signals, privacy level adjustments, triggering event detection, and color calibration, this method may enhance the usability and flexibility of the display apparatus. The method may be applicable to laptops, tablets, smartphones, and other display devices, ensuring an intelligent and seamless user experience.

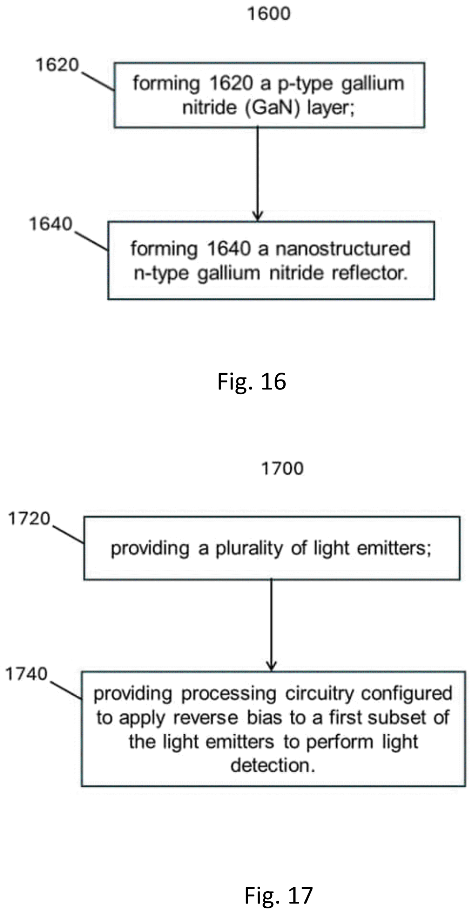

More details and aspects are mentioned in connection with the embodiments described above or below. The example shown in Fig. 15 may comprise one or more optional additional features corresponding to one or more aspects mentioned in connection with the proposed concept or one or more examples described above (e.g. Fig. 1-14) or below (e.g. Fig. 16-17).

Fig. 16 illustrates a method 1600 of manufacturing a light emitter of an example.

In some examples, a method 1600 of manufacturing a light emitter, such as emitter 1200, may include forming 1620 a p-type gallium nitride (GaN) layer, such as layer 1220, and forming 1640 a nanostructured n-type gallium nitride reflector, such as layer 1240. This method may be used to fabricate high-efficiency MicroLEDs, where the nanostructured reflector may enhance light extraction by reflecting emitted photons towards the viewing surface.

In some examples, the nanostructured n-type GaN reflector may include a Distributed Bragg Reflector (DBR) structure. The DBR may be formed by alternating layers of materials with different refractive indices, which may optimize reflectivity and reduce light losses. By incorporating nano-porosity, the DBR may achieve fine control over the refractive index contrast, ensuring high reflectivity at targeted wavelengths.

The method may further include disposing an active region between the p-type GaN layer and the nanostructured n-type GaN reflector, where the active region may include indium gallium nitride (InGaN). In some examples, the active region may include one or more quantum wells, which may enhance carrier confinement, leading to higher efficiency in photon generation. The quantum wells may be formed from thin InGaN layers sandwiched between GaN barrier layers, providing an optimized emission spectrum based on the desired wavelengths of operation.

To maximize light output, the method may further include configuring the nanostructured n-type GaN reflector to reflect light emitted from the active region towards a light extraction surface. The high reflectivity of the nanostructured DBR may ensure that light may not be absorbed within the substrate but instead redirected efficiently toward the desired output direction, thereby improving device brightness and efficiency.

In some examples, the method may further include forming nano-sized pores in the n-type GaN reflector in a periodic pattern. The precise arrangement of these pores may enable tunable refractive index modulation, further enhancing the optical performance of the DBR. The periodic patterning may be achieved through techniques such as electrochemical etching, which may allow controlled porosity formation while maintaining the structural integrity of the GaN reflector.

The method may also include forming a transparent conductive layer over the p-type GaN layer. This layer may enable uniform current distribution across the emission area while ensuring minimal optical absorption. In some examples, indium tin oxide (ITO) or other transparent conductive oxides (TCOs) may be used for this purpose, providing a low-resistance electrical connection while maintaining high transparency for light extraction.

To enhance device durability and performance, the method may further include covering a passivation layer on at least a portion of the nanostructured n-type GaN reflector. The passivation layer may help protect the reflector from environmental degradation, such as oxidation or contamination, and may also reduce surface recombination losses. Materials such as silicon nitride (Si₃N₄) or silicon dioxide (SiO₂) may be used as passivation layers to provide electrical insulation while preserving the optical integrity of the structure.

By implementing this method, the manufactured light emitter may achieve high efficiency, improved brightness, and better thermal stability, making it suitable for MicroLED display applications. The integration of nanostructured reflectors, quantum wells, and transparent conductive layers may enable next-generation display technologies that may offer superior visual performance and energy efficiency for applications such as wearable displays, smartphones, automotive lighting, and augmented reality (AR) systems.

More details and aspects are mentioned in connection with the embodiments described above or below. The example shown in Fig. 16 may comprise one or more optional additional features corresponding to one or more aspects mentioned in connection with the proposed concept or one or more examples described above (e.g. Fig. 1-15) or below (e.g. Fig. 17).

Fig. 17 illustrates a method 1700 of manufacturing a display apparatus of an example.

In some examples, a method 1700 of manufacturing a display apparatus, such as the display apparatus 1300, may include providing 1720 a plurality of light emitters, such as emitters 1320, and providing 1740 processing circuitry, such as circuitry1340, configured to apply reverse bias to a first subset, such as emitters1320-2, of the light emitters to perform light detection. This method may enable the light emitters to function both as light sources and as photodetectors, integrating light emission and detection capabilities within the display.

In some examples, the method may further include providing an Indium Gallium Nitride (InGaN) layer between two un-doped GaN quantum barriers. The InGaN layer may be responsible for photon generation when forward biased and for detecting incident light when reverse biased. The thickness of the InGaN layer may be thinner than either of the two un-doped GaN quantum barriers, ensuring a well-defined quantum well structure that may enhance light emission and detection efficiency.

In a specific example, the InGaN layer may have a thickness of 5 nm, while each of the two un-doped GaN quantum barriers may have a thickness of 12 nm. This structural configuration may optimize the separation of electron-hole pairs under reverse bias conditions, improving photo-detection sensitivity while maintaining efficient light emission under forward bias.

The processing circuitry may be provided to selectively switch between applying forward bias for light emission and applying reverse bias for light detection to the first subset of light emitters. This capability may enable the display to dynamically switch between active display mode and ambient light sensing mode without requiring additional external sensors. The processing circuitry may also apply different reverse bias voltages to different subsets of light emitters, allowing for localized light sensing based on different regions of the display.

To ensure adaptive functionality, the processing circuitry may be configured to adjust the intensity of the reverse bias applied to the first subset of light emitters according to changes in the intensity of ambient light. For example, if ambient light increases, the reverse bias voltage may be adjusted to enhance light detection sensitivity. Conversely, in low-light conditions, the bias voltage may be reduced to avoid unnecessary power consumption while maintaining effective detection capabilities.

**In** addition to light sensing, the processing circuitry may be configured to adjust display brightness based on light detection data. This function may ensure that the display may dynamically adapt to different lighting environments, improving readability and power efficiency. Moreover, the processing circuitry may be configured to compensate for pixel aging by adjusting forward bias voltages of some of the light emitters in response to pixel aging detected through light detection. This compensation may maintain uniform brightness across the display, even as individual light emitters degrade over time.

To facilitate optimized light emission and detection, the method may further include providing an array of pixels, where each pixel may include at least one light emitter configured for both light emission and light detection at different time slots. This dual-functionality may reduce the need for separate light sensors, streamlining display fabrication while enhancing functionality.

**In** some examples, the method may further include providing the plurality of light emitters in a matrix pattern, where the first subset of light emitters used for light detection may be periodically distributed across the matrix. This distribution may allow for a balanced arrangement of light emitting and light-detecting pixels, ensuring consistent performance across the display.

The processing circuitry may also be configured to detect external light sources based on light detection data and generate a control signal to compensate for glare by adjusting display contrast.

This functionality may enhance screen readability in high-glare environments, making the display suitable for outdoor and bright settings.

**In** some examples, the first subset of light emitters configured for light detection may include MicroLEDs. These MicroLEDs may be designed to operate as photodetectors under reverse bias, leveraging quantum well structures to detect incoming photons with high sensitivity and fast response times. The use of MicroLEDs for light detection may improve display efficiency by eliminating external ambient light sensors, while maintaining compactness and integration within modern display architectures.

By integrating reverse-biased light emitters, quantum well structures, and adaptive processing circuitry, this method may provide a cost-effective, power-efficient, and highly responsive display solution. The manufactured display apparatus may be suitable for a range of applications, including smartphones, tablets, laptops, augmented reality (AR) devices, and automotive displays, where real-time ambient light adaptation and energy efficiency may be essential.

More details and aspects are mentioned in connection with the embodiments described above or below. The example shown in Fig. 17 may comprise one or more optional additional features corresponding to one or more aspects mentioned in connection with the proposed concept or one or more examples described above (e.g. Fig. 1-16)

An example (e.g., example 1) relates to a display apparatus comprising: a first light emitting structure configured to emit narrow light for a first display mode; and a second light emitting structure configured to emit wide light for a second display mode, wherein an emission angle of the narrow light is smaller than an emission angle of the wide light. The first light emitting structure and the second light emitting structure may be micro light emitting structures like MicroLEDs.

An example (e.g., example 2) relates to a previously described example (e.g., example 1) or to any of the examples described herein, wherein the first light emitting structure has an emission angle of at most 40 degrees.

An example (e.g., example 3) relates to a previously described example (e.g., examples 1 or 2) or to any of the examples described herein, wherein the second light emitting structure has an emission angle of at least 100 degrees.

An example (e.g., example 4) relates to a previously described example (e.g., any one of examples 1 to 3) or to any of the examples described herein, wherein the first light emitting structure comprises at least three emitters configured to emit red light, green light, and blue light, and wherein the second light emitting structure comprises at least three emitters configured to emit red light, green light, and blue light.

An example (e.g., example 5) relates to a previously described example (e.g., any one of examples 1 to 4) or to any of the examples described herein, wherein the first light emitting structure is a first sub-pixel and the second light emitting structure is a second sub-pixel.

An example (e.g., example 6) relates to a previously described example (e.g., any one of examples 1 to 5) or to any of the examples described herein, wherein the first light emitting structure is a first LED structure and the second light emitting structure is a second LED structure.

An example (e.g., example 7) relates to a previously described example (e.g., example 6) or to any of the examples described herein, wherein the first LED structure and the second LED structure are two different MicroLED structures.

An example (e.g., example 8) relates to a previously described example (e.g., any one of examples 1 to 7) or to any of the examples described herein, wherein the first light emitting structure comprises a nanostructured n-type gallium nitride reflector.

An example (e.g., example 9) relates to a previously described example (e.g., example 8) or to any of the examples described herein, wherein the reflector comprises pores with a maximal dimension of less than 50 nm.

An example (e.g., example 10) relates to a previously described example (e.g., example 8 or 9) or to any of the examples described herein, wherein the reflector is a Distributed Bragg Reflector.

An example (e.g., example 11) relates to a previously described example (e.g., any one of examples 1 to 10) or to any of the examples described herein, further comprising: control circuitry configured to selectively activate either the first light emitting structure for the first display mode or the second light emitting structure for the second display mode.

An example (e.g., example 12) relates to a previously described example (e.g., example 11) or to any of the examples described herein, wherein the control circuitry comprises at least one of a button or a software-based interface for activating the first or second display mode.

An example (e.g., example 13) relates to an apparatus comprising: processing circuitry configured to generate a control signal for triggering a light emission of a first sub-pixel of a pixel in a first display mode and triggering a light emission of a second sub-pixel of the pixel in a second display mode; and an output interface for providing the control signal to a display.

An example (e.g., example 14) relates to a previously described example (e.g., example 13) or to any of the examples described herein, wherein the processing circuitry is further configured to adjust the intensity of light emission of the first sub-pixel in the first display mode based on a privacy level setting.

An example (e.g., example 15) relates to a previously described example (e.g., example 14) or to any of the examples described herein, wherein the privacy level setting is based on at least one of a user input or an environmental condition.

An example (e.g., example 16) relates to a previously described example (e.g., any one of examples 13 to 15) or to any of the examples described herein, further comprising at least one of a button or a software-based interface, which is configured to transmit an instruction to the processing circuitry.

An example (e.g., example 17) relates to a previously described example (e.g., any one of examples 13 to 16) or to any of the examples described herein, further comprising a sensor configured to detect a triggering event for display mode switching.

An example (e.g., example 18) relates to a previously described example (e.g., example 17) or to any of the examples described herein, wherein the triggering event comprises at least one of a user gesture or change of a number of viewers within a predefined field of view of the display.

An example (e.g., example 19) relates to a previously described example (e.g., any one of examples 13 to 18) or to any of the examples described herein, wherein the processing circuitry is further configured to generate an additional control signal for triggering a light emission of a third sub-pixel of the pixel based on a color calibration setting.

An example (e.g., example 20) relates to a light emitter comprising: a p-type gallium nitride layer; and a nanostructured n-type gallium nitride reflector having a plurality of pores with a maximal dimension of less than 50 nm.

An example (e.g., example 21) relates to a previously described example (e.g., example 20) or to any of the examples described herein, wherein the nanostructured n-type gallium nitride reflector comprises a distributed Bragg reflector structure.

An example (e.g., example 22) relates to a previously described example (e.g., example 20 or 21) or to any of the examples described herein, further comprising an active region disposed between the p-type gallium nitride layer and the nanostructured n-type gallium nitride reflector, wherein the active region comprises indium gallium nitride (InGaN).

An example (e.g., example 23) relates to a previously described example (e.g., example 22) or to any of the examples described herein, wherein the active region comprises one or more quantum wells.

An example (e.g., example 24) relates to a previously described example (e.g., any one of examples 20 to 23) or to any of the examples described herein, wherein the nanostructured n-type gallium nitride reflector is configured to reflect light emitted from the active region towards a light extraction surface.

An example (e.g., example 25) relates to a previously described example (e.g., any one of examples 20 to 24) or to any of the examples described herein, wherein the pores are formed in a periodic pattern.

An example (e.g., example 26) relates to a previously described example (e.g., any one of examples 20 to 25) or to any of the examples described herein, further comprising a transparent conductive layer formed over the p-type gallium nitride layer.

An example (e.g., example 27) relates to a previously described example (e.g., any one of examples 20 to 26) or to any of the examples described herein, wherein the light emitter is configured for use in a MicroLED display.

An example (e.g., example 28) relates to a previously described example (e.g., any one of examples 20 to 27) or to any of the examples described herein, further comprising a passivation layer covering at least a portion of the nanostructured n-type gallium nitride.

An example (e.g., example 29) relates to a display apparatus comprising: a plurality of light emitters; and processing circuitry configured to apply reverse bias to a first subset of the light emitters to perform light detection.

An example (e.g., example 30) relates to a previously described example (e.g., example 29) or to any of the examples described herein, wherein the processing circuitry is configured to selectively switch between applying forward bias for light emission and the reverse bias for light detection to the first subset of the light emitters.

An example (e.g., example 31) relates to a previously described example (e.g., example 29 or 30) or to any of the examples described herein, wherein the processing circuitry is configured to apply different reverse bias voltages to different subsets of light emitters.

An example (e.g., example 32) relates to a previously described example (e.g., any one of examples 29 to 31) or to any of the examples described herein, wherein the processing circuitry is configured to adjust the intensity of the reverse bias applied to the first subset of the light emitters according to a change in the intensity of ambient light.

An example (e.g., example 33) relates to a previously described example (e.g., any one of examples 29 to 32) or to any of the examples described herein, wherein the processing circuitry is configured to adjust display brightness based on the light detection.

An example (e.g., example 34) relates to a previously described example (e.g., example 33) or to any of the examples described herein, wherein the processing circuitry is configured to compensate for pixel aging by adjusting forward bias voltages of some of the light emitters responsive to pixel aging determined based on the light detection.

An example (e.g., example 35) relates to a previously described example (e.g., any one of examples 29 to 34) or to any of the examples described herein, wherein the processing circuitry is configured to detect a user in proximity based on the light detection and adjust the brightness of the display apparatus based on the detected user.

An example (e.g., example 36) relates to a previously described example (e.g., any one of examples 29 to 35) or to any of the examples described herein, wherein the display apparatus comprises an array of pixels, each pixel including at least one light emitter configured for both light emission and light detection at different time slots.

An example (e.g., example 37) relates to a previously described example (e.g., any one of examples 29 to 36) or to any of the examples described herein, wherein the plurality of light emitters are arranged in a matrix pattern, and the first subset of light emitters used for light detection is periodically distributed across the matrix.

An example (e.g., example 38) relates to a previously described example (e.g., any one of examples 29 to 37) or to any of the examples described herein, wherein the processing circuitry is configured to detect external light sources based on the light detection and generate a control signal to compensate for glare by adjusting display contrast.

An example (e.g., example 39) relates to a previously described example (e.g., any one of examples 29 to 38) or to any of the examples described herein, wherein the first subset of the light emitters configured for light detection comprises MicroLEDs.

An example (e.g., example 40) relates to a method of manufacturing a display apparatus, comprising: providing a plurality of pixels on a display backplane, each pixel comprising: a first sub-pixel configured to emit narrow light for a first display mode, and a second sub-pixel configured to emit wide light for a second display mode, wherein an emission angle of the narrow light is smaller than an emission angle of the wide light.

An example (e.g., example 41) relates to a previously described example (e.g., example 40) or to any of the examples described herein, further comprising fabricating a nanostructured n-type gallium nitride reflector in the first sub-pixel.

An example (e.g., example 42) relates to a previously described example (e.g., example 40 or 41) or to any of the examples described herein, wherein the method further comprises transferring, based on a pick-and-place (PnP) technique, at least one of the first sub-pixel or the second sub-pixel to the backplane.

An example (e.g., example 43) relates to a previously described example (e.g., any one of examples 40 to 42) or to any of the examples described herein, wherein the first light emitting structure has an emission angle of at most 40 degrees.

An example (e.g., example 44) relates to a previously described example (e.g., any one of examples 40 to 43) or to any of the examples described herein, wherein the second light emitting structure has an emission angle of at least 100 degrees.

An example (e.g., example 45) relates to a previously described example (e.g., any one of examples 40 to 44) or to any of the examples described herein, wherein the first light emitting structure comprises at least three emitters configured to emit red light, green light, and blue light, and wherein the second light emitting structure comprises at least three emitters of a second type, being configured to emit red light, green light, and blue light.

An example (e.g., example 46) relates to a previously described example (e.g., any one of examples 40 to 45) or to any of the examples described herein, wherein the first light emitting structure is a first sub-pixel and the second light emitting structure is a second sub-pixel.

An example (e.g., example 47) relates to a previously described example (e.g., any one of examples 40 to 46) or to any of the examples described herein, wherein the first light emitting structure is a first light emitting diode (LED) structure and the second light emitting structure is a second **LED** structure.

An example (e.g., example 48) relates to a previously described example (e.g., example 47) or to any of the examples described herein, wherein the first **LED** structure and the second **LED** structure are two different MicroLED structures.

An example (e.g., example 49) relates to a previously described example (e.g., example 41) or to any of the examples described herein, further comprising forming nano-sized pores on the nanostructured n-type gallium nitride reflector.

An example (e.g., example 50) relates to a previously described example (e.g., example 41 or 49) or to any of the examples described herein, wherein the reflector is a distributed Bragg reflector.

An example (e.g., example 51) relates to a previously described example (e.g., any one of examples 40 to 50) or to any of the examples described herein, further comprising integrating control circuitry into the display apparatus, wherein the control circuitry is configured to selectively activate either the first light emitting structure for the first display mode or the second light emitting structure for the second display mode.

An example (e.g., example 52) relates to a previously described example (e.g., example 51) or to any of the examples described herein, wherein the control circuitry comprises at least one of a button or a software-based interface for activating the first or second display mode.

An example (e.g., example 53) relates to a method for controlling a display apparatus, comprising: generating a control signal for triggering a light emission of a first sub-pixel of a pixel in a first display mode and triggering a light emission of a second sub-pixel of the pixel in a second display mode; and providing the control signal to a display.

An example (e.g., example 54) relates to a previously described example (e.g., example 53) or to any of the examples described herein, further comprising adjusting the intensity of light emission of the first sub-pixel in the first display mode based on a privacy level setting.

An example (e.g., example 55) relates to a previously described example (e.g., example 54) or to any of the examples described herein, further comprising configuring the privacy level setting based on at least one of a user input or an environmental condition.

An example (e.g., example 56) relates to a previously described example (e.g., any one of examples 53 to 55) or to any of the examples described herein, further comprising detecting a triggering event for switching a display mode.

An example (e.g., example 57) relates to a previously described example (e.g., example 56) or to any of the examples described herein, wherein the triggering event comprises at least one of a user gesture or a change in the number of viewers within a predefined field of view.

An example (e.g., example 58) relates to a previously described example (e.g., any one of examples 53 to 57) or to any of the examples described herein, further comprising generating an additional control signal for triggering a light emission of a third sub-pixel of the pixel based on a color calibration setting.

An example (e.g., example 59) relates to a method of manufacturing a light emitter, comprising: forming a p-type gallium nitride layer; and forming a nanostructured n-type gallium nitride reflector.

An example (e.g., example 60) relates to a previously described example (e.g., example 59) or to any of the examples described herein, wherein the nanostructured n-type gallium nitride reflector comprises a Distributed Bragg Reflector (DBR) structure.

An example (e.g., example 61) relates to a previously described example (e.g., example 59 or 60) or to any of the examples described herein, further comprising disposing an active region between the p-type gallium nitride layer and the nanostructured n-type gallium nitride reflector, wherein the active region comprises indium gallium nitride (InGaN).

An example (e.g., example 62) relates to a previously described example (e.g., example 61) or to any of the examples described herein, wherein the active region comprises one or more quantum wells.

An example (e.g., example 63) relates to a previously described example (e.g., any one of examples 59 to 62) or to any of the examples described herein, further comprising configuring the nanostructured n-type gallium nitride reflector to reflect light emitted from the active region towards a light extraction surface.

An example (e.g., example 64) relates to a previously described example (e.g., any one of examples 59 to 63) or to any of the examples described herein, further comprising forming the nano-sized pores in a periodic pattern.

An example (e.g., example 65) relates to a previously described example (e.g., any one of examples 59 to 64) or to any of the examples described herein, further comprising forming a transparent conductive layer over the p-type gallium nitride layer.

An example (e.g., example 66) relates to a previously described example (e.g., any one of examples 59 to 65) or to any of the examples described herein, further comprising covering a passivation layer on at least a portion of the nanostructured n-type gallium nitride reflector.

An example (e.g., example 67) relates to a method of manufacturing a display apparatus, comprising: providing a plurality of light emitters; and providing processing circuitry configured to apply reverse bias to a first subset of the light emitters to perform light detection.

An example (e.g., example 68) relates to a previously described example (e.g., example 67) or to any of the examples described herein, further comprising providing an Indium Gallium Nitride (InGaN) layer between two un-doped GaN quantum barriers.

An example (e.g., example 69) relates to a previously described example (e.g., example 68) or to any of the examples described herein, wherein the InGaN layer is thinner than any of the two un-doped GaN quantum barriers.

An example (e.g., example 70) relates to a previously described example (e.g., example 68 or 69) or to any of the examples described herein, wherein a thickness of the InGaN layer is 5 nm, and wherein a thickness of any of the two un-doped GaN quantum barriers is 12 nm.

An example (e.g., example 71) relates to a previously described example (e.g., any one of examples 67 to 70) or to any of the examples described herein, wherein the processing circuitry is provided to selectively switch between applying a forward bias for light emission and a reverse bias for light detection to the first subset of the light emitters.

An example (e.g., example 72) relates to a previously described example (e.g., any one of examples 67 to 71) or to any of the examples described herein, wherein the processing circuitry is provided to apply different reverse bias voltages to different subsets of light emitters.

An example (e.g., example 73) relates to a previously described example (e.g., any one of examples 67 to 72) or to any of the examples described herein, wherein the processing circuitry is provided to adjust the intensity of the reverse bias applied to the first subset of the light emitters according to a change in the intensity of ambient light.

An example (e.g., example 74) relates to a previously described example (e.g., any one of examples 67 to 73) or to any of the examples described herein, wherein the processing circuitry is provided to adjust display brightness based on the light detection.

An example (e.g., example 75) relates to a previously described example (e.g., example 74) or to any of the examples described herein, wherein the processing circuitry is configured to compensate for pixel aging by adjusting forward bias voltages of some of the light emitters in response to pixel aging determined based on the light detection.

An example (e.g., example 76) relates to a previously described example (e.g., any one of examples 67 to 75) or to any of the examples described herein, further comprising providing an array of pixels, each pixel including at least one light emitter configured for both light emission and light detection at different time slots.

An example (e.g., example 77) relates to a previously described example (e.g., any one of examples 67 to 76) or to any of the examples described herein, further comprising providing the plurality of light emitters in a matrix pattern, and the first subset of light emitters used for light detection is periodically distributed across the matrix.

An example (e.g., example 78) relates to a previously described example (e.g., any one of examples 67 to 77) or to any of the examples described herein, wherein the processing circuitry is configured to detect external light sources based on the light detection and generate a control signal to compensate for glare by adjusting display contrast.

An example (e.g., example 79) relates to a previously described example (e.g., any one of examples 67 to 78) or to any of the examples described herein, wherein the first subset of the light emitters configured for light detection comprises MicroLEDs.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

**It** is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

**If** some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

As used herein, the term "module" refers to logic that may be implemented in a hardware component or device, software or firmware running on a processing unit, or a combination thereof, to perform one or more operations consistent with the present disclosure. Software and firmware may be embodied as instructions and/or data stored on non-transitory computer-readable storage media. As used herein, the term "circuitry" can comprise, singly or in any combination, non-programmable (hardwired) circuitry, programmable circuitry such as processing units, state machine circuitry, and/or firmware that stores instructions executable by programmable circuitry. Modules described herein may, collectively or individually, be embodied as circuitry that forms a part of a computing system. Thus, any of the modules can be implemented as circuitry. A computing system referred to as being programmed to perform a method can be programmed to perform the method via software, hardware, firmware, or combinations thereof.

Any of the disclosed methods (or a portion thereof) can be implemented as computer-executable instructions or a computer program product. Such instructions can cause a computing system or one or more processing units capable of executing computer-executable instructions to perform any of the disclosed methods. As used herein, the term "computer" refers to any computing system or device described or mentioned herein. Thus, the term "computer-executable instruction" refers to instructions that can be executed by any computing system or device described or mentioned herein.

The computer-executable instructions can be part of, for example, an operating system of the computing system, an application stored locally to the computing system, or a remote application accessible to the computing system (e.g., via a web browser). Any of the methods described herein can be performed by computer-executable instructions performed by a single computing system or by one or more networked computing systems operating in a network environment. Computer-executable instructions and updates to the computer-executable instructions can be downloaded to a computing system from a remote server.

Further, it is to be understood that implementation of the disclosed technologies is not limited to any specific computer language or program. For instance, the disclosed technologies can be implemented by software written in C++, C#, Java, Perl, Python, JavaScript, Adobe Flash, C#, assembly language, or any other programming language. Likewise, the disclosed technologies are not limited to any computer system or type of hardware.

Furthermore, any of the software-based examples (comprising, for example, computer-executable instructions for causing a computer to perform any of the disclosed methods) can be uploaded, downloaded, or remotely accessed through a suitable communication means. Such suitable communication means include, for example, the Internet, the World Wide Web, an intranet, cable (including fiber optic cable), magnetic communications, electromagnetic communications (including RF, microwave, ultrasonic, and infrared communications), electronic communications, or other such communication means.

The disclosed methods, apparatuses, and systems are not to be construed as limiting in any way. Instead, the present disclosure is directed toward all novel and nonobvious features and aspects of the various disclosed examples, alone and in various combinations and sub-combinations with one another. The disclosed methods, apparatuses, and systems are not limited to any specific aspect or feature or combination thereof, nor do the disclosed examples require that any one or more specific advantages be present, or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A display apparatus, comprising:
a first micro light emitting structure of a pixel, wherein the first micro light emitting structure is configured to emit a narrow light for a first display mode; and
a second micro light emitting structure of the pixel, wherein the second micro light emitting structure is configured to emit a wide light for a second display mode, wherein an emission angle of the narrow light is smaller than an emission angle of the wide light.

2. The display apparatus of claim 1, wherein the first micro light emitting structure has an emission angle of at most 40 degrees.

3. The display apparatus of one of claims 1-2, wherein the second micro light emitting structure has an emission angle of at least 100 degrees.

4. The display apparatus of one of claims 1-3, wherein the first micro light emitting structure comprises at least three emitters configured to emit red light, green light, and blue light, and wherein the second micro light emitting structure comprises at least three emitters configured to emit red light, green light, and blue light.

5. The display apparatus of one of claims 1-4, wherein the first micro light emitting structure is a first sub-pixel and the second micro light emitting structure is a second sub-pixel.

6. The display apparatus of one of claims 1-5, wherein the first micro light emitting structure comprises a nanostructured n-type gallium nitride reflector.

7. The display apparatus of one of claims 1-6, further comprising:
control circuitry configured to selectively activate either the first micro light emitting structure for the first display mode or the second micro light emitting structure for the second display mode.

8. An apparatus comprising:
processing circuitry configured to generate a control signal for triggering a light emission of a first sub-pixel of a pixel in a first display mode and triggering a light emission of a second sub-pixel of the pixel in a second display mode; and
an output interface for providing the control signal to a display.

9. The apparatus of claim 8, wherein the processing circuitry is further configured to adjust intensity of light emission of the first sub-pixel in the first display mode based on a privacy level setting.

10. The apparatus of one of claims 8-9, wherein the processing circuitry is further configured to generate an additional control signal for triggering a light emission of a third sub-pixel of the pixel based on a color calibration setting.

11. A display apparatus, comprising:
a plurality of light emitters; and
processing circuitry configured to apply reverse bias to a first subset of the light emitters to perform light detection.

12. The display apparatus of claim 11, wherein the processing circuitry is configured to selectively switch between applying forward bias for light emission and the reverse bias for light detection to the first subset of the light emitters.

13. The display apparatus of one of claims 11-12, wherein the processing circuitry is configured to apply different reverse bias voltages to different subsets of light emitters.

14. The display apparatus of one of claims 11-13, wherein the processing circuitry is configured to adjust intensity of the reverse bias applied to the first subset of the light emitters according to a change of intensity of ambient light.

15. The display apparatus of one of claims 11-14, wherein the processing circuitry is configured to adjust display brightness based on the light detection, or wherein the processing circuitry is configured to detect a user in proximity based on the light detection and adjust a brightness of the display apparatus based on the detected user.
